Europäisches Patentamt

European Patent Office

Office européen des brevets

(11) Publication number: 0 335 420 A2

## EUROPEAN PATENT APPLICATION

(21) Application number: 89105722.6

(22) Date of filing: 31.03.89

(51) Int. Cl.⁴: H05K 3/34 , H05K 3/32

(30) Priority: 31.03.88 JP 80024/88

(43) Date of publication of application:
04.10.89 Bulletin 89/40

(84) Designated Contracting States:
DE FR GB IT

(71) Applicant: KABUSHIKI KAISHA TOSHIBA
72, Horikawa-cho Saiwai-ku
Kawasaki-shi Kanagawa-ken 210(JP)

Applicant: TOSHIBA MICRO-COMPUTER
ENGINEERING CORPORATION
25-1, Ekimae-hon-cho Kawasaki-ku
Kawasaki-shi Kanagawa-ken(JP)

(72) Inventor: Noguchi, Eiichi
2-11-6, Motobuto
Urawa-Shi Saitama-Ken(JP)
Inventor: Ohno, Jun-ichi 1-24-24,
Nagata-Higashi
Minami-Ku Yokohama-Shi
Kanagawa-Ken(JP)
Inventor: Shindo, Masamichi 56, Zenbu-Cho
Asahi-Ku Yokohama-Shi
Kanagawa-Ken(JP)

(74) Representative: Lehn, Werner, Dipl.-Ing. et al
Hoffmann, Eitle & Partner Patentanwälte
Arabellastrasse 4
D-8000 München 81(DE)

(54) Electrical and mechanical joint construction between a printed wiring board and a lead pin.

(57) An electrical and mechanical joint construction between a wiring board (1) and a lead pin (4) for semiconductor devices, comprising a single sided wiring board (1) having a wiring pattern (2) formed on one side only. The lead pin (4) has one end thereof inserted in a hole (1a) in the wiring board. Solder or like joint material is applied only to the printed side of the wiring board for electrically connecting the one end of the elad pin to the wiring pattern (2). The joint material is thus prevented from providing a short circuit between the lead pin (4) and a metal made baseplate (6) which supports the lead pin and which is held against the blank side of the wiring board.

FIG. I

# ELECTRICAL AND MECHANICAL JOINT CONSTRUCTION BETWEEN A PRINTED WIRING BOARD AND A LEAD PIN

## BACKGROUND OF THE INVENTION

This invention relates to an improved joint construction providing electrical and mechanical connection between a printed wiring board and a lead pin in semiconductor devices. The joint construction according to the invention is particularly well calculated to avoid short circuiting between lead pins and a metal made baseplate which is held against the wiring board and through which extend the lead pins.

The wiring boards of semiconductor devices have usually been double sided, with conductor patterns printed, as by etching, on both sides. In order to connect the conductor patterns to lead pins, the wiring board has holes formed therethrough each for receiving one end of one lead pin with substantial clearance. The wiring patterns on both sides of the board are electrically connected to the lead pins as solder is introduced into the clearances left in the board holes by the lead pins. The solder serves the additional purpose of providing firm mechanical joint between the wiring board and the lead pins.

A serious inconvenience has been encountered with this prior art joint construction when a metal made baseplate is employed in combination with the lead pins. The lead pins extend through clearance holes in the baseplate and are secured to, but insulated from, the baseplate as by a vitreous material filled in the clearance holes. With this baseplate held flatwise against the wiring board, the lead pins are soldered to the wiring patterns on the board in the manner set forth above. However, according to the prior art, the solder has been very prone to flow into contact with the metal made baseplate. The result has been the shorting of the lead pins and the baseplate.

The same inconvenience manifests itself with the hermetically sealed package of a printed wiring board and a semiconductor chip suggested by Japanese Patent Application No. 61-280225 filed by the assignee of the instant application. This prior art device is intended to overcome the higher manufacturing costs and other shortcomings of the more conventional ceramic packages and plastic packages. It teaches the use of a metal made baseplate with a semiconductor chip arranged centrally thereon. The baseplate is held against the wiring board, and the lead pins are joined to the wiring board. Then the wiring board and the semiconductor chip are hermetically sealed in a metal shell. The noted shorting problem has proved to arise in soldering the lead pins to the wiring board, the latter being in direct contact with the metal made baseplate holding the lead pins.

## SUMMARY OF THE INVENTION

The present invention provides a solution to the problem of how to avoid, in mechanically and electrically joining lead pins to a wiring board, shorts between the lead pins and the metal made baseplate held against the wiring board.

Briefly, the invention may be summarized as a joint construction comprising a single sided wiring board having a desired wiring pattern formed on one side only. A lead pin has one end thereof inserted in a hole in the wiring board. Solder or like electrically conducting joint material is applied only to said one side of the wiring board so as to electrically connect the one end of the lead pin to the wiring pattern on the wiring board.

The single sided wiring board permits the wiring pattern thereon to be soldered or otherwise electrically joined to the lead pin by the joint material applied to only one side of the board. The joint material is totally absent from the other side of the wiring board. A metal made baseplate may therefore be held against this blank side of the wiring board without the fear of shorting with the elad pin via the joint material. As an additional advantage, the invention requires the use of a significantly less amount of the joint material than the prior art using double sided wiring boards.

The above and other features and advantages of this invention and the manner of realizing them will become more apparent, and the invention itself will best be understood, from a study of the following description and appended claims, with reference had to the attached drawings showing some preferable embodiments of the invention.

## BRIEF DESCRIPTION OF THE DRAWINGS

FIG. 1 is a sectional illustration of a typical form of the joint construction according to the invention;

FIG. 2 is a similar illustration of another preferred form of the joint construction according to the invention; and

FIG. 3 is a similar illustration of still another preferred form of the joint construction according to the invention.

## DESCRIPTION OF THE PREFERRED EMBODIMENTS

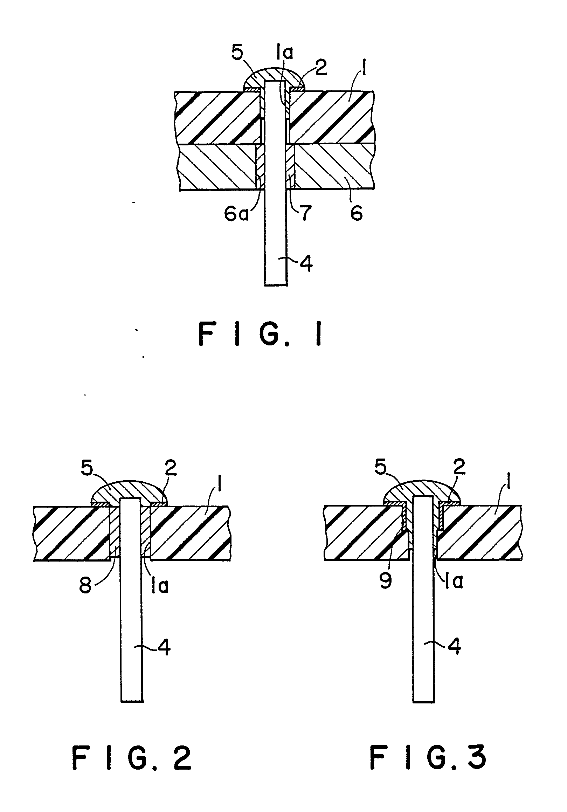

In the typical joint construction illustrated in FIG. 1 is a wiring board is shown fragmentarily and designated 1. This wiring board 1 is single sided; that is, a wiring pattern 2 of any desired design is formed on only one side, shown directed upwardly, of the wiring board as by the familiar etching method. The wiring board 1 itself may be molded from reinforced plastics, an example being epoxy resin reinforced with a network of glass fibers.

Any required number of clearance holes, one shown at 1a, are formed in required positions through the wiring board 1. Each clearance hole 1a receives one end of a rigid lead pin 4 with relatively small clearance. If the diameter of the lead pin 4 is 0.45 millimeter, for example, then the clearance hole 1a may be 0.70 millimeter or so in diameter, providing a clearance of approximately 0.25 millimeter.

At 5 is seen an electrically conducting joint material, usually solder, that is applied to the top side of the wiring board 1 so as to electrically connect the lead pin 4 to the wiring pattern 2. The clearance left in the hole 1a is calculated to permit the solder 5 to flow halfway down therein. Consequently, the solder 5 serves the additional purpose of mechanically firmly coupling the lead pin 4 to the wiring board 1.

Projecting downwardly out of the clearance hole 1a in the wiring board 1, the lead pin 4 extends through a larger clearance hole 6a in a baseplate 6 which is made of metal such as an alloy of iron and nickel. This metal made baseplate 6 is held flatwise against the blank underside of the wiring board 1. The clearance hole 6a in the baseplate 6 is larger in diameter than the clearance hole 1a in the wiring board 1 and is axially aligned therewith. An electrically insulating material 7 is filled in the gap left in the clearance hole 6a by the lead pin 4. Glass is recommended as the insulating filler material 7. Thus the lead pin 4 is electrically insulated from the baseplate 6 but is rigidly coupled thereto mechanically.

In the joint construction disclosed hereinbefore with reference to FIG. 1, the use of the single sided wiring board 1 eliminates the need for causing the joint material 5 to flow down through the clearance hole 1a to the blank underside of the wiring board. The joint material 5 electrically connects the lead pin 4 to the wiring pattern 2 only on the exposed top side of the wiring board 1. Since the joint material is totally absent from the underside of the wiring board 1, there is no possibility of the joint material forming a short circuit between the lead pin 4 and the metal made baseplate 6.

In another preferred embodiment of the invention illustrated in FIG. 2, the clearance hole 1a formed in the single sided wiring board 1 is somewhat greater in diameter than that of the FIG. 1 embodiment. The lead pin 4 extends through the clearance hole 1a, leaving a clearance that is filled with an electrically insulating material 8 such as glass. As in the FIG. 1 embodiment the lead pin 4 has its exposed top end electrically coupled to the wiring pattern 2 on the top side of the wiring board 1 by the solder 5 or like joint material. The vitreous insulating material 8 serves the dual purpose of positively joining the lead pin 4 to the wiring board 1 and of preventing the joint material 5 from flowing through the clearance hole 1a to the blank underside of the wiring board.

FIG. 3 shows still another preferred embodiment of the invention, in which the relatively small diameter clearance hole 1a in the wiring board 1 is counterbored to provide a flat bottomed enlargement 9 open to the top side of the wiring board. Extending through the clearance hole 1a including the counterbore 9, the lead pin 4 has its top end electrically coupled to the wiring pattern 2 by the solder 5 or like joint material. It will be observed that the joint material 5 intrudes into the counterbore 9 of the clearance hole 1a thereby firmly joining the lead pin 4 to the wiring board 1 mechanically. The joint material in the counterbore 9 serves also to provide a more positive electric connection between wiring poattern 2 and lead pin 4.

It is understood that the combinations of the wiring board 1 and lead pin 4 shown in FIGS. 2 and 3 are both put to use with the metal made baseplate 6 of FIG. 1. As has been explained in connection with FIG. 1, the baseplate 6 may be held against the blank side of the wiring board 1 of FIG. 2 or 3, receiving the lead pin 4 in its clearance hole 6a via the vitreous insulating material 7. The embodiments of FIGS. 2 and 3 are akin in the other details of construction to the FIG. 1 embodiment.

Additional embodiments of the invention, as well as various modifications of the embodiments disclosed herein, may be readily contemplated by one skilled in the art without departing from the scope of the invention.

## Claims

1. A joint construction between a wiring board (1) and a lead pin (4), characterized in that the wiring board (1) is single sided, with a desired wiring pattern (2) formed on one side only, that the lead pin (4) has one end thereof inserted in a hole (1a) in the wiring board, and that an electrically conducting joint material (5) is applied only to said one side of the wiring board so as to electrically connect the lead pin to the wiring pattern on the wiring board.

2. A joint construction as claimed in claim 1 characterized in that the hole (1a) in the wiring board (1) receives the lead pin (4) with a clearance, and that the joint material (5) fills at least part of the clearance.

3. A joint construction as claimed in claim 1, characterized in that the hole (1a) in the wiring board (1) receives the lead pin (4) with a clearance, and that the clearance is filled with an electrically insulating material (8).

4. A joint construction as claimed in claim 1, characterized in that the hole (1a) in the wiring board (1) has a counterbore (9), and that the joint material (5) fills the counterbore.

F I G. I

F I G. 2

F I G. 3